# EUROPÄISCHE PATENTSCHRIFT

(11) **EP 4 097 759 B1**
(45) Veröffentlichungstag und Bekanntmachung des Hinweises auf die Patenterteilung: **18.10.2023**
(21) Anmeldenummer: 20829788.7
(22) Anmeldetag: 16.12.2020
(51) Int. Cl.: H01L 23/367, H01L 23/467

(54) **WÄRMEABLEITUNGSVORRICHTUNG**
HEAT DISSIPATION DEVICE
DISPOSITIF DE DISSIPATION DE CHALEUR

(30) Priorität: 27.01.2020 AT 500592020
(43) Veröffentlichungstag der Anmeldung: 07.12.2022
(73) Patentinhaber: 4Motec GmbH & Co Kg, 8020 Graz (AT)
(72) Erfinder: KRAMMER, Gert, 8042 Graz (AT); PÖLLMANN, Gerald, 8010 Graz (AT)
(74) Vertreter: Schwarz & Partner Patentanwälte GmbH
(86) Internationale Anmeldenummer: PCT/AT2020/060465
(87) Internationale Veröffentlichungsnummer: WO 2021/151130

(56) Entgegenhaltungen:
- EP-A2- 2 369 620
- DE-A1- 10 153 512
- US-A- 5 701 951
- US-A- 6 161 610
- US-A1- 2005 252 642
- US-A1- 2006 042 782
- US-A1- 2010 108 292

## Beschreibung

Die vorliegende Erfindung betrifft eine Wärmeableitungsvorrichtung zur Anordnung an zumindest einem elektronischen Bauteil, umfassend eine wärmeleitende Basisplatte mit einem Boden und einer vom Boden abgewandten Oberseite, wobei sich zwischen zwei einander gegenüberliegenden Stirnseiten der Basisplatte Wärmeableitungslamellen von der Oberseite der Basisplatte quer über die Basisplatte und in Bezug auf die Oberseite der Basisplatte geneigt erstrecken. Die Neigungen der Wärmeableitungslamellen in Bezug auf die Oberseite der Basisplatte sind so ausgebildet, dass benachbarte Wärmeableitungslamellen abwechselnd aufeinander zulaufen und voneinander weglaufen, wobei die benachbarten, aufeinander zulaufenden Wärmeableitungslamellen an ihren von der Oberseite der Basisplatte abgewandten Endbereichen direkt oder mittels einer Deckwand miteinander verbunden sind und einen ersten Luftströmungskanal begrenzen und die benachbarten, voneinander weglaufenden Wärmeableitungslamellen einen zweiten Luftströmungskanal begrenzen, der an seiner von der Oberseite der Basisplatte abgewandten Seite offen ist, wobei die Wärmeableitungslamellen eine Vielzahl von Belüftungslöchern und/oder Belüftungsschlitzen aufweisen.

Einhergehend mit einer ständigen Erhöhung der Leistung von elektronischen Bauteilen und Hardware in elektronischen Geräten steht die Forderung, durch kompaktere Bauweise und höhere Integrationsdichte zumindest die gleichen Funktionen in kleineren Volumina auszuführen. Da die Lebensdauer und Funktionalität elektronischer Komponenten direkt von einer ausreichenden Wärmeabfuhr abhängig sind, ist es erforderlich, parallel zur Erhöhung der Leistung die Kapazität der Kühlung zu erhöhen. Die Aufgabe der zusätzlichen Kühlung muss entweder das Gehäuse des Elektroniksystems oder ein Kühlkörper übernehmen.

Die mögliche Wärmeabfuhr und die zur Kühlung zur Verfügung stehende Oberfläche sind voneinander abhängig. Kühlkörper werden demzufolge regelmäßig so ausgelegt, dass sie ihre Wärmeabgabe durch Vergrößerung der effektiven Oberfläche des elektronischen Bauteils erhöhen. Daneben stehen höchste Forderungen hinsichtlich der Wärmeleitfähigkeit des eingesetzten Materials, seiner Masse und des daraus resultierenden Gesamtgewichts dieser Einheit.

Ein Kühlkörper der genannten Art ist in der Patentschrift US 5701951A offenbart. Figur 3 dieser Patentschrift zeigt einen Kühlkörper, der eine Haltevorrichtung oder eine U-förmige Halteplatte 30, eine Lüftereinheit 40, die auf der Halteplatte 30 gelagert ist, eine wärmeleitende horizontale Grundplatte 50, die dazu ausgelegt ist, die obere Oberfläche einer zentralen Verarbeitungseinheit 20 zu kontaktieren, und eine gewellte, aus mehreren V-förmigen Abschnitten 61 bestehenden, poröse Wärmeableitplatte 60 umfasst, die aus einem flexiblen wärmeleitenden Material hergestellt und auf der Grundplatte 50 befestigt ist. Die Wärmeableitplatte 60 weist hierbei eine Vielzahl von Belüftungslöchern 62 auf, die über der Grundplatte 50 und unter der Wärmeableitungsplatte definiert sind. Über die Löcher 62 kann mittels der Lüftereinheit ein Luftstrom in den Belüftungsräumen 63 erzeugt werden. Die Haltevorrichtung bzw. die U-förmige Halteplatte 30 besteht aus einer horizontalen Deckwand 31 und zwei vertikalen Seitenwänden 32. Jede der Seitenwände 32 hat eine Innenfläche, die in dem unteren Endabschnitt 33 mit einem offenen horizontalen Schlitz 34 ausgebildet ist. Die offenen horizontalen Schlitze 34 der Haltevorrichtung bzw. der U-förmigen Halteplatte 30 greifen jeweils in zwei gegenüberliegende Seitenabschnitte 51 der Grundplatte 50 ein, um die Lüftereinheit 40 auf der Grundplatte 50 über der gewellten Wärmeableitplatte 60 zu halten.

Die Ausgestaltung der Haltevorrichtung, insbesondere die Anordnung der Seitenwände an den distalen Enden der Belüftungsräume, des vorliegenden Standes der Technik verhindert es, dass die in den Belüftungsräumen befindliche und von den elektronischen Bauteilen erwärmte Luft aus den distalen Enden der Belüftungsräume ausströmen kann. Bei einer U-förmigen Ausführung der Haltevorrichtung wird zusätzlich das Ausströmen der erwärmten Luft quer zu den Belüftungsräumen an zumindest einer weiteren Seite der Wärmeableitplatte verhindert. Die oben genannten Nachteile haben zur Folge, dass die erwärmte Luft kaum beziehungsweise nur langsam aus der Wärmeableitplatte entweichen kann und somit die wärmeabgebenden elektronischen Bauteile nicht mehr ausreichend gekühlt werden können bzw. die elektronischen Bauteile sich kontinuierlich weitererwärmen. Verstärkt wird dieser Effekt durch den von der Lüftereinheit erzeugten und auf die Wärmableitplatte geblasenen Luftstrom. Dieser Luftstrom verursacht insbesondere im Zentrum der Wärmeableitplatte einen Druckabfall und sorgt damit für eine deutlich geringere Luftabströmgeschwindigkeit der erwärmten Luft. Es können sogenannte "hot spots" im Zentrum der Wärmeableitplatte entstehen.

Ein weiterer Nachteil des in US 5701951A offenbarten Kühlkörpers ist, dass aufgrund der Ausgestaltung der Wärmeableitplatte im Zusammenwirken mit der Anordnung der Seitenwände der Haltevorrichtung an den distalen Enden der Belüftungsräume, die von der Wärmeableitplatte zu entweichende erwärmte Luft in die Belüftungsräume zurückströmen und die erwärmte Luft die Belüftungsräume dadurch mehrmals passieren kann. Dies hat einen verstärkten negativen Einfluss auf die Kühlwirkung des Kühlkörpers des gegenständlichen Standes der Technik.

Es besteht daher Bedarf, eine Vorrichtung herzustellen, die die oben genannten Nachteile vermeidet, und die mit einem Minimum an Material, Volumen und Oberfläche einen maximalen Wärmeübertrag erreichen kann.

Die vorliegende Erfindung löst die gestellten Aufgaben durch Bereitstellen einer Wärmeableitungsvorrichtung mit den Merkmalen des Anspruchs 1. Vorteilhafte Ausgestaltungen der Erfindung ergeben sich aus den Unteransprüchen, der Beschreibung und den Zeichnungen.

Bei der erfindungsgemäßen Wärmeableitungsvorrichtung sind die ersten Luftströmungskanäle an ihren einander gegenüberliegenden distalen Enden offen und die zweiten Luftströmungskanäle an ihren einander gegenüberliegenden distalen Enden geschlossen ausgebildet. Vorteilhaft ist, dass hierdurch eine erzwungene Luftströmung entsteht, die es ermöglicht, eine möglichst gleichmäßige Druckverteilung innerhalb der Wärmeableitungslamellen zu schaffen, wodurch die von den elektronischen Bauteilen erwärmte Luft effizient abgeführt werden kann. Hierdurch ist eine verbesserte Kühlung dieser Bauteile möglich. Die Luftzuströmung und die Luftabströmung erfolgen vorzugsweise über unterschiedliche Achsen. Beispielsweise kann die Luftzuströmung über eine vertikale Achse erfolgen und die Luftabströmung über eine quer zur vertikalen Achse verlaufende horizontale Achse oder umgekehrt, wenn der Lüfter im Saugbetrieb betrieben wird. Die größte Wärmeübertragung erfolgt dabei vorwiegend innerhalb der Vielzahl von Belüftungslöchern und/oder Belüftungsschlitzen der Wärmeableitungslamellen, wobei der Luftstrom die Belüftungslöcher und/oder Belüftungsschlitze vorzugsweise nur einmal passiert.

In einer bevorzugten Ausführungsform weisen die ersten Luftströmungskanäle eine im Wesentlichen trapezförmige Querschnittsform auf. Hierdurch kann ein enger Lamellenabstand erzielt werden und dennoch ein ausreichender Strömungsquerschnitt in den zweiten Luftströmungskanälen gewährleistet werden. Durch Parallelschalten einer Vielzahl von ersten Luftströmungskanälen kann eine niedrige Bauhöhe erzielt werden die nur geringe Temperaturverluste zwischen Basisplatte und Lamellenspitze verursacht.

In einer bevorzugten Ausführungsform sind die distalen Enden der zweiten Luftströmungskanäle durch Quetschung der Enden geschlossen ausgebildet. Hierdurch kann kosteneffizient und zeitsparend die oben genannte erzwungene Luftströmung innerhalb der Belüftungslöcher und/oder der Belüftungsschlitze hergestellt werden. Die genannten zweiten Luftströmungskanäle weisen bevorzugt eine im Wesentlichen V-förmige Querschnittsform auf.

In einer bevorzugten Ausführungsform ist die Summe der Querschnittsflächen aller ersten Luftströmungskanäle kleiner als die Summe der Flächen der Belüftungslöcher bzw. Belüftungsschlitze in den die ersten Luftströmungskanäle begrenzenden Wärmeableitungslamellen. Besonders vorteilhaft ist hierbei, dass bei einer zur Deckwand vertikal zugeführten Zuluftströmung eine hohe Luftabströmgeschwindigkeit der abzuführenden warmen Luft erlaubt. Damit wird Bauvolumen der ersten Luftströmungskanäle eingespart.

In einer bevorzugten Ausführungsform weist die Oberseite der Basisplatte Rippen auf, auf denen die Wärmeableitungslamellen angeordnet sind. Die genannten Rippen weisen hierbei eine im Wesentlichen gleiche Breite auf, als die der Oberseite der Basisplatte zugewandten Enden der benachbarten, voneinander weglaufenden Wärmeableitungslamellen. Die dadurch entstehende Kontaktfläche kann die Wärmeübertragung von der Basisplatte an die Wärmableitungslamellen begünstigen. Die genannten Rippen können durch spanende Fertigungsverfahren, beispielsweise durch Fräsen, hergestellt sein.

In einer alternativen Ausführungsform weist die Oberseite der Basisplatte Schlitze auf, in die die Wärmeableitungslamellen eingesetzt sind. Im Zuge der Herstellung der Wärmeableitungsvorrichtung können hierdurch die Wärmeableitungslamellen in einem ersten Schritt auf der Oberseite der Basisplatte vorpositioniert werden, bevor die Wärmeableitungslamellen in einem weiteren Schritt mit der Basisplatte beispielsweise durch Kleben, Löten, Verpressen, Reibschweißen, Laserschweißen oder andere im Stand der Technik bekannte Verfahren fest verbunden werden. Zudem können die Schlitze, abhängig von deren Tiefe, den Wärmeableitungslamellen zusätzliche Stabilität gegenüber mechanischer Beanspruchung bieten, was besonders vorteilhaft ist, wenn die gegenständliche Wärmeableitungsvorrichtung beispielsweise Vibrationen ausgesetzt ist. Wie bei der zuvor genannten bevorzugten Ausführungsform, weisen die Schlitze eine im Wesentlichen gleiche Breite auf, als die der Oberseite der Basisplatte zugewandten Enden der benachbarten, voneinander weglaufenden Wärmeableitungslamellen. Durch die in dieser Ausführungsform entstehende Kontaktfläche kann die Wärmeübertragung von der Basisplatte an die Wärmableitungslamellen begünstigt werden. Die genannten Schlitze können durch spanende Fertigungsverfahren, beispielsweise durch Fräsen, hergestellt sein. Die Basisplatte kann auch durch Druckguss oder durch Kaltfließpressen hergestellt sein.

In einer bevorzugten Ausführungsform sind die Wärmeableitungslamellen mit den Rippen oder Schlitzen mittels einer stoffschlüssigen Verbindung, insbesondere einer wärmeleitfähigen Klebeverbindung, verbunden. Hierdurch kann eine einfache und kostengünstige Verbindung von Basisplatte und Wärmeableitungslamellen hergestellt werden, die eine optimale Wärmeübertragung von der Basisplatte an die Wärmeableitungslamellen ermöglichen kann.

In einer bevorzugten Ausführungsform bestehen die Wärmeableitungslamellen aus Kupfer oder Aluminium. Kupfer und Aluminium weisen eine sehr gute Wärmeleitfähigkeit auf, die dazu genützt werden kann, um die von den elektronischen Bauteilen abgegebene Wärme von der Basisplatte an die Wärmeableitungslamellen besonders effizient zu übertragen. Des Weiteren ist vorteilhaft, dass Aluminium ein mechanisch leicht zu bearbeitendes Metall ist, wodurch die Wärmeableitungslamellen ohne großen technischen Aufwand und infolgedessen kostengünstig hergestellt werden können.

In einer bevorzugten Ausführungsform besteht die Basisplatte aus einem Metall, insbesondere aus Aluminium, Kupfer, einem Kupfer-Aluminium Verbund oder einer Legierung, wobei die Oberflächen der Basisplatte zumindest in jenen Abschnitten, die zum Anliegen an dem zumindest einen elektronischen Bauteil vorgesehen sind, eine elektrisch isolierende Schicht, insbesondere eine Eloxalschicht, aufweisen. Durch die gute Wärmeleitfähigkeit von Aluminium kann die von den elektronischen Bauteilen abgegebene thermische Energie über die zuvor genannte Kontaktfläche nahezu verlustfrei an die Wärmeableitungslamellen übertragen werden. Die Eloxalschicht hat im Vergleich zu anderen elektrischen Isolatoren, wie beispielsweise Kunstharz, den Vorteil, dass die beim Eloxal-Verfahren erzeugte oxidische Schutzschicht eine günstigere Wärmeleitfähigkeit aufweist.

In einer bevorzugten Ausführungsform ist der Boden der Basisplatte dazu ausgebildet, an dem zumindest einen elektronischen Bauteil angeordnet zu werden, indem er mit reliefartigen Vertiefungen versehen ist, deren Gestalt und Dimension im Wesentlichen der Kontur des elektronischen Bauteils entspricht. Hierdurch ist es möglich, die elektronischen Bauteile mit der Basisplatte so zu kontaktieren, dass zwischen der Oberfläche der elektronischen Bauteile und den reliefartigen Vertiefungen des Bodens der Basisplatte im Wesentlichen nur ein dünner Spalt gebildet wird. Dieser dünne Spalt wird mit einem gut wärmeleitfähigem Material wie Wärmeleit-Paste, -Gel, -Phase-change Material, -Schaumstoff oder -Vergussmasse luftfrei ausgefüllt. Zudem kann durch die reliefartigen Vertiefungen der Boden der Basisplatte mit einer der elektronischen Bauteile umfassenden Leiterplatte ebenfalls im Wesentlichen luftspaltfrei, wie oben beschreiben gut wärmeleitend kontaktiert werden. Zusätzlich zu der von den Bauteilen erzeugte Wärme kann die von der Leiterplatte abgegebene Wärme an die Basisplatte übertragen werden. Die Vertiefungen sind dabei durch den Stand der Technik bekannte Methoden wie beispielsweise durch Fräsen oder Prägen herstellbar.

In einer bevorzugten Ausführungsform sind die Belüftungslöcher der Wärmeableitungslamellen als Rundlöcher und/oder Langlöcher ausgebildet. Hierdurch kann ein von beispielsweise einem Lüfter erzeugter Luftstrom im Wesentlichen ungehindert von dem ersten Luftströmungskanal in den zweiten Luftströmungskanal oder umgekehrt strömen. Zudem kann durch die Vielzahl der Belüftungslöcher und, im Fall von Rundlöchern, der kreisrunden Ausbildung dieser Belüftungslöcher eine größtmögliche Fläche auf einem kleinen Raum gebildet werden, die es erlaubt, in den zuvor genannten ersten und zweiten Luftströmungskanälen unterschiedliche Strömungsgeschwindigkeiten zu schaffen, wodurch Wärme rascher abgeführt werden kann. Zu erwähnen sei, dass die Belüftungslöcher neben Rund- und Langlöcher jede weitere geometrische Form aufweisen können, wie polygone Formen oder beispielsweise eine Ellipsenform.

In einer bevorzugten Ausführungsform sind die Belüftungsschlitze der Wärmeableitungslamellen parallel zueinander und senkrecht auf die Oberseite der Basisplatte stehend in den Wärmeableitungslamellen ausgebildet. Hierdurch kann die zuvor genannte von den Belüftungslöchern gebildete Fläche zunehmend vergrößert werden, wodurch eine noch effizientere Luftströmung zwischen dem ersten Luftströmungskanal und dem zweiten Luftströmungskanal geschaffen werden kann. Die Belüftungsschlitze sind durch spanende Fertigungsverfahren, vorzugsweise durch Sägen, herstellbar.

In einer bevorzugten Ausführungsform sind die Wärmeableitungslamellen als Strangpressprofile ausgebildet. Vorteilhaft ist, dass die Wärmeableitungslamellen hierdurch mit einem hohen Umformgrad sowie kostengünstig hergestellt werden können. Die Strangpressprofile können durch unterschiedliche Strangpressverfahren hergestellt sein wie z. B. durch direkte, indirekte oder hydrostatische Strangpressverfahren. Des Weiteren können die Wärmeableitungslamellen und die Basisplatte auch einstückig durch Strangpressen hergestellt werden. Vorteilhaft ist hierbei, dass die von den Bauteilen gebildete Wärme nahezu verlustfrei ohne den Einsatz eines wärmeleitfähigen Klebstoffes über die Wärmeableitungslamellen abgeführt werden kann. Die Wärmeableitungslamellen können jedoch auch durch andere Verfahren hergestellt werden und sind demnach nicht auf die Herstellung mittels Strangpressen beschränkt. So können die Wärmeableitungslamellen beispielsweise durch 3D-Druck hergestellt sein, wobei als Werkstoff beispielsweise Metallfilamente eingesetzt werden können, die eine Mischung aus Metallpulvern (z.B. Aluminium oder Kupfer) und Kunststoffen (z. B. PLA oder ABS) umfassen. Die Wärmeableitungslamellen können auch aus einem Metallblech hergestellt sein, welches gebogen und mit der Basisplatte verklebt ist. Die Belüftungslöcher und/oder Belüftungsschlitze sind beispielsweise durch Ätzen, Stanzen oder Schneiden herstellbar. Letzteres kann z. B. Laserschneiden oder Wasserstrahlschneiden sein. Vorzugsweise sind die Wärmeableitungslamellen als trapezförmige Spiralfedern ausgebildet.

In einer bevorzugten Ausführungsform weist die Wärmeableitungsvorrichtung zumindest einen über den Wärmeableitungslamellen angeordneten elektrischen Lüfter auf, wobei der Lüfter im Betrieb einen Luftstrom in die offenen zweiten Luftströmungskanäle bläst und der zumindest eine Lüfter an den Stirnseiten der Basisplatte oder an sich an den oder nahe der Stirnseiten der Basisplatte erhebenden Seitenwänden montiert ist. Vorteilhaft ist, dass hierdurch der für die Kühlung der elektronischen Bauteile notwendige Luftstrom an die Menge der abzuführenden Wärme angepasst werden kann. So kann der zumindest eine Lüfter bei hoher Wärmeabgabe der elektronischen Bauteile mit maximaler Leistung d. h. mit höchstmöglicher Drehzahl, betrieben werden und umgekehrt, wodurch die elektronischen Bauteile in nahezu jedem Betriebsmodus ausreichend gekühlt werden können. Bei elektronischen Bauteilen mit besonders starker Wärmeabgabe und/oder bei der Kühlung von einer Vielzahl von elektronischen Bauteilen ist es vorgesehen einen zweiten elektrischen Lüfter über den Wärmeableitungslamellen, parallel zu dem ersten Lüfter an den Stirnseiten der Basisplatte oder an den Seitenwänden der Basisplatte anzuordnen. Dieser zweite Lüfter weist im Wesentlichen die gleichen technischen Eigenschaften auf, als der zuvor beschriebene erste elektrische Lüfter. Die Lüfter sind mit der Stirnseite der Basisplatte oder mit den oben genannten Seitenwänden verklebbar und/oder mittels Befestigungsmittel wie beispielsweise Schrauben befestigbar. In einer alternativen Ausführung ist es vorgesehen, dass der genannte Luftstrom ohne den Gebrauch eines Lüfters erzeugt werden kann. So kann beispielsweise der durch ein bewegtes Fahrzeug erzeugte Fahrtwind als Luftstrom zur Kühlung der oben genannten Bauteile verwendet werden. Dies ist besonders vorteilhaft für Zweiräder wie z. B. Motorräder, da, je nach Einbauort der Wärmeableitungsvorrichtung, der Fahrtwind die Wärmeableitungsvorrichtung im Wesentlichen vollständig durchströmen kann. Vorteilhaft ist, dass hierdurch die von den Lüftern im Betrieb erzeugten Lüftergeräusche vermieden werden können. Jedoch sind hierfür bestimmte Voraussetzungen notwendig, die eingehalten werden müssen, um eine ausreichende Kühlung der elektronischen Bauteile zu erreichen. Beispielsweise sollten Stehzeiten größtenteils vermieden werden und vorgegebene Mindestgeschwindigkeiten eingehalten werden, um eine Überhitzung der Bauteile zu vermeiden. In einer weiteren alternativen Ausführung können die Lüfter derart ausgebildet sein, sodass diese Luft ansaugen anstatt Luft auf die Wärmeableitungslamellen zu blasen. Ein Wechsel von Luftzuström- und Luftabströmrichtung kann in bestimmten Einsatzgebieten vorteilhaft sein, wenn es beispielsweise zwingend erforderlich ist, eine äußerst gleichmäßige Druckverteilung innerhalb der Wärmeableitlamellen zu schaffen. Zudem ermöglicht dies ein Entstauben der Kühllamellen oder das Ausblasen von angesaugten Fremdkörpern.

In einer bevorzugten Ausführungsform ist der zumindest eine Lüfter mittels eines mit allen Wärmeableitungslamellen 30 an den distalen Enden 34` der zweiten Luftströmungskanäle 34 verbundenen Montageelements an den an den Stirnseiten der Basisplatte oder an sich an den oder nahe der Stirnseiten der Basisplatte erhebenden Seitenwänden montiert. Das Montageelement kann dabei mit der Stirnseite der Basisplatte oder mit den Seitenwänden verklebt und/oder oder mittels Befestigungsmittel wie beispielsweise Schrauben befestigt sein. Das Material des Montageelements ist vorzugsweise Kunststoff, wobei das Montageelement auch aus jedem anderen Material wie z. B. Metall sein kann. Vorteilhaft ist, dass das Montagelement den elektrischen Lüftern zusätzliche Stabilität verleiht und die Lüfter dadurch besser vor mechanischer Beanspruchung geschützt werden können.

Die Erfindung wird nun unter Bezugnahme auf die Zeichnungen anhand von nicht einschränkenden Ausführungsbeispielen näher erläutert.
Figur 1 zeigt eine perspektivische Ansicht einer Wärmeableitungsvorrichtung gemäß der vorliegenden Erfindung in einer bevorzugten Ausführungsform;
Figur 2 zeigt eine perspektivische Vorderansicht der Wärmeableitungsvorrichtung mit einem Luftströmungsverlauf;
Figur 3 zeigt Wärmeableitungslamellen gemäß der vorliegenden Erfindung mit an einander gegenüberliegenden distalen Enden offenen bzw. geschlossenen Luftströmungskanälen;
Figur 4 zeigt eine Vorderansicht der Wärmeableitungslamellen;
Figur 5 zeigt eine perspektivische Vorderansicht von Belüftungsschlitzen aufweisenden Wärmeableitungslamellen;
Figur 6 zeigt eine perspektivische Vorderansicht der in Schlitzen einer Basisplatte angeordneten Wärmeableitungslamellen;
Figur 7 zeigt eine perspektivische Ansicht der Wärmeableitungsvorrichtung von unten;

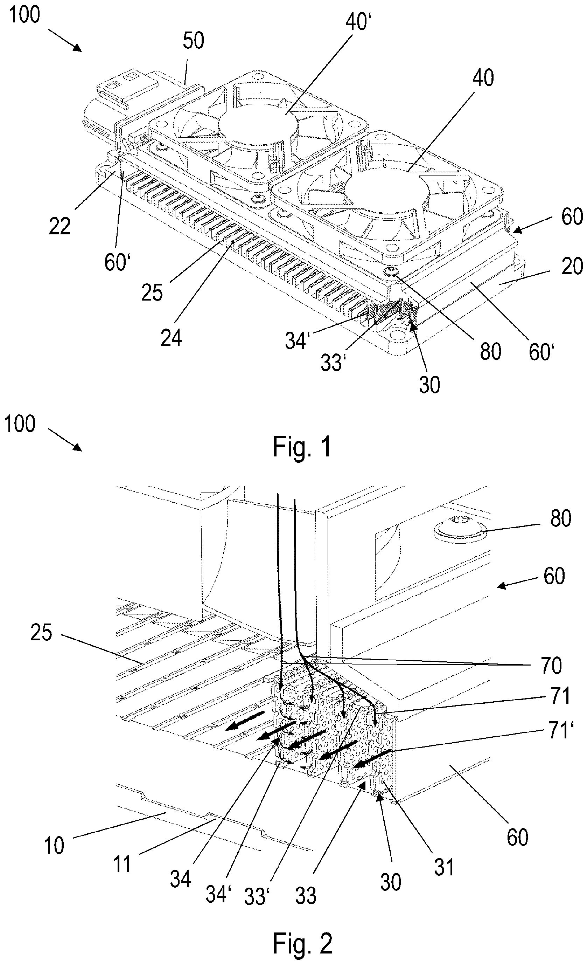

Im Folgenden wird auf die Zeichnungen und zunächst auf die Figuren 1 und 2 Bezug genommen. Demnach umfasst die gegenständliche Erfindung eine Wärmeableitungsvorrichtung 100 zur Anordnung an zumindest einem elektronischen Bauteil 11. Die Wärmeableitungsvorrichtung 100 umfasst ferner eine wärmeleitende Basisplatte 20 mit einem Boden 21 und einer vom Boden 21 abgewandten Oberseite 22, wobei sich zwischen zwei einander gegenüberliegenden Stirnseiten der Basisplatte 20 Wärmeableitungslamellen 30 von der Oberseite 22 der Basisplatte 20 quer über die Basisplatte 20 und in Bezug auf die Oberseite der Basisplatte 20 geneigt erstrecken. Die Basisplatte besteht hierbei aus Metall, insbesondere Aluminium, oder einer Legierung, wobei die Oberflächen der Basisplatte zumindest in jenen Abschnitten, die zum Anliegen an dem zumindest einen elektronischen Bauteil vorgesehen sind, eine elektrisch isolierende Schicht, insbesondere eine Eloxalschicht, aufweisen. Die Neigungen der Wärmeableitungslamellen 30 in Bezug auf die Oberseite 22 der Basisplatte 20 sind so ausgebildet, dass benachbarte Wärmeableitungslamellen 30 abwechselnd aufeinander zulaufen und voneinander weglaufen. Die benachbarten, aufeinander zulaufenden Wärmeableitungslamellen sind an ihren von der Oberseite 22 der Basisplatte 20 abgewandten Endbereichen direkt oder mittels einer Deckwand 32 miteinander verbunden und begrenzen einen ersten Luftströmungskanal 33. Die benachbarten, voneinander weglaufenden Wärmeableitungslamellen 30 begrenzen einen zweiten Luftströmungskanal 34, der an seiner von der Oberseite 22 der Basisplatte 20 abgewandten Seite offen ist. Die ersten Luftströmungskanäle 33 weisen hierbei eine im Wesentlichen trapezförmige Querschnittsform auf. Die Wärmeableitungslamellen 30 weisen eine Vielzahl von Belüftungslöchern 31 und/oder Belüftungsschlitzen 31' auf, wobei die Summe der Querschnittsflächen aller ersten Luftströmungskanäle kleiner ist als die Summe der Flächen der Belüftungslöcher 31 bzw. Belüftungsschlitze 3 1' in den die ersten Luftströmungskanäle 33 begrenzenden Wärmeableitungslamellen 30. Die ersten Luftströmungskanäle 33 sind hierbei an ihren einander gegenüberliegenden distalen Enden 33' offen und die zweiten Luftströmungskanäle 34 an ihren einander gegenüberliegenden distalen Enden 34` durch Quetschung der Enden geschlossen ausgebildet. Um die genannten Enden 34` geschlossen auszubilden, können auch andere dem Stand der Technik bekannte Methoden eingesetzt werden und ist daher nicht auf die Quetschung dieser Enden 34` beschränkt. Die oben genannten Wärmeableitungslamellen 30 sind als Strangpressprofile ausgebildet, wobei diese durch unterschiedliche Strangpressverfahren hergestellt werden können wie z. B. durch direkte, indirekte oder hydrostatische Strangpressverfahren. Des Weiteren können die Wärmeableitungslamellen 30 und die Basisplatte 20 auch einstückig durch Strangpressen hergestellt sein. Ein weiteres Fertigungsverfahren zur Herstellung der Wärmeableitungslamellen 30 könnte 3D-Druck sein, wobei als Werkstoff beispielsweise Metallfilamente eingesetzt werden können, die eine Mischung aus Metallpulvern (z.B. Aluminium oder Kupfer) und Kunststoffen (z. B. PLA oder ABS) umfassen. In einem weiteren, anderen Fertigungsverfahren könnten die Wärmeableitungslamellen 30 auch aus einem Metallblech hergestellt sein, welches gebogen und mit der Basisplatte 20 verklebt ist. Die Belüftungslöcher 31 und/oder Belüftungsschlitze 31' können hierbei beispielsweise durch Ätzen, Stanzen oder Schneiden hergestellt werden. Letzteres kann z. B. Laserschneiden oder Wasserstrahlschneiden sein. Gemäß einer alternativen Ausführungsvariante der erfindungsgemäßen Wärmeableitungsvorrichtung 100 sind die Wärmeableitungslamellen 30 als trapezförmige Spiralfedern ausgebildet.

Wie in Figur 1 ersichtlich weist die Oberseite 22 der Basisplatte 20 Rippen 24 auf, auf denen die aus Kupfer oder Aluminium bestehende Wärmeableitungslamellen 30 angeordnet sind. Alternativ, wie in Figur 2 dargestellt, kann die Oberseite 22 der Basisplatte 20 Schlitze 25 aufweisen, in die die Wärmeableitungslamellen 30 eingesetzt sind. In beiden Ausführungsformen sind die Wärmeableitungslamellen 30 mit den Rippen 24 oder Schlitzen 25 mittels einer stoffschlüssigen Verbindung, insbesondere einer wärmeleitfähigen Klebeverbindung, verbunden.

Ferner zeigt Figur 1 die zweiten Luftströmungskanäle 34 mit geschlossenen, d. h. gequetschten, einander gegenüberliegenden distalen Enden 34`, wobei Figur 2 einen Schnitt durch die Wärmeableitungsvorrichtung bzw. einen Schnitt durch die zweiten Luftströmungskanäle 34 veranschaulicht.

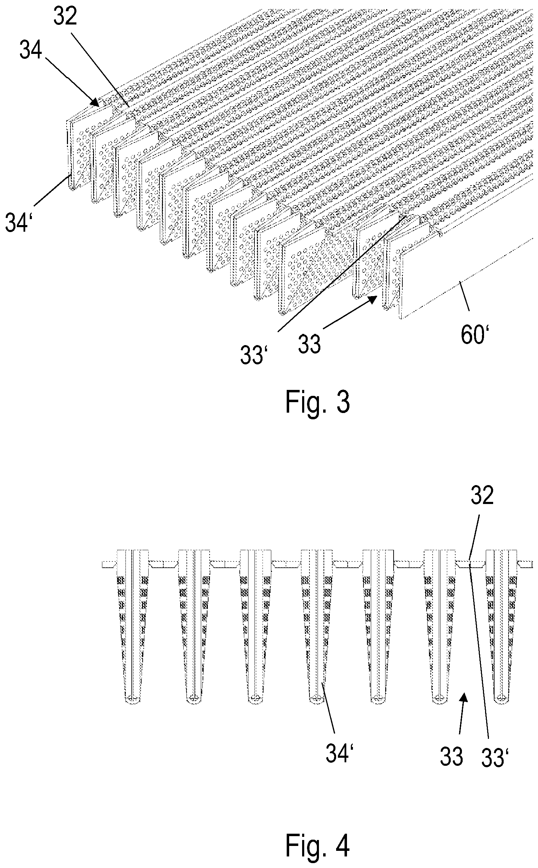

Figur 3 und 4 zeigen die Wärmeableitungslamellen 30 mit den ersten Luftströmungskanälen 33 und den zweiten Luftströmungskanälen 34 im Detail. Hierbei sind, gemäß der vorliegenden Erfindung, die einander gegenüberliegenden distalen Enden 33' der ersten Luftströmungskanäle 33 offen und die einander gegenüberliegenden distalen Enden 34` der zweiten Luftströmungskanäle 34 geschlossenen, insbesondere gequetscht. Die Belüftungslöcher 31 der Wärmeableitungslamellen 30 sind dabei als Rundlöcher und/oder Langlöcher ausgebildet. Neben Rundlöcher und Langlöcher können die Wärmeableitungslamellen jede weitere geometrische Form aufweisen.

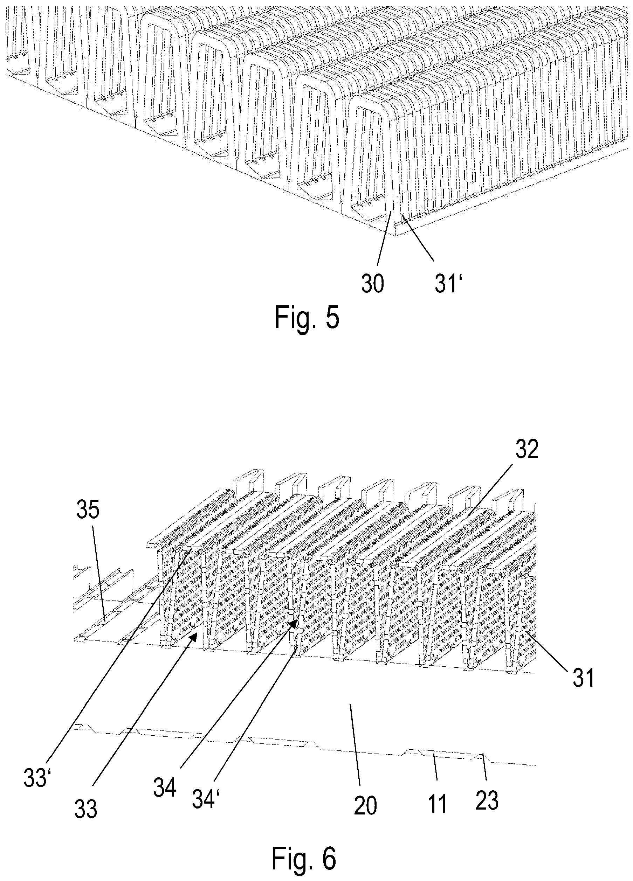

In Figur 5 sind Wärmeableitungslamellen 30 mit Belüftungsschlitzen 31' dargestellt, die parallel zueinander und senkrecht auf die Oberseite 22 der Basisplatte 20 stehend, in den Wärmeableitungslamellen 30 ausgebildet sind und durch spanende Fertigungsverfahren, vorzugsweise durch Sägen, hergestellt werden können. Die Wärmeableitungslamellen 30 können auch eine Kombination von Belüftungslöchern 31 und Belüftungsschlitzen 31' aufweisen.

Figur 6 zeigt einen Schnitt durch die Wärmeableitungsvorrichtung 100 und die Anordnung der Wärmeableitungslamellen 30 in Schlitzen 25 der Oberseite 22 der Basisplatte 20. Wie oben beschrieben, sind die Wärmeableitungslamellen 30 mit der Basisplatte 20 mittels einer stoffschlüssigen Verbindung, insbesondere einer wärmeleitfähigen Klebeverbindung, verbunden. Aus Gründen der Anschaulichkeit sind die in Figur 6 abgebildeten zweiten Luftströmungskanäle 34 an einem distalen Ende 34` offen und an einem dem distalen Ende 34` gegenüberliegendem Ende mittels Quetschung geschlossen.

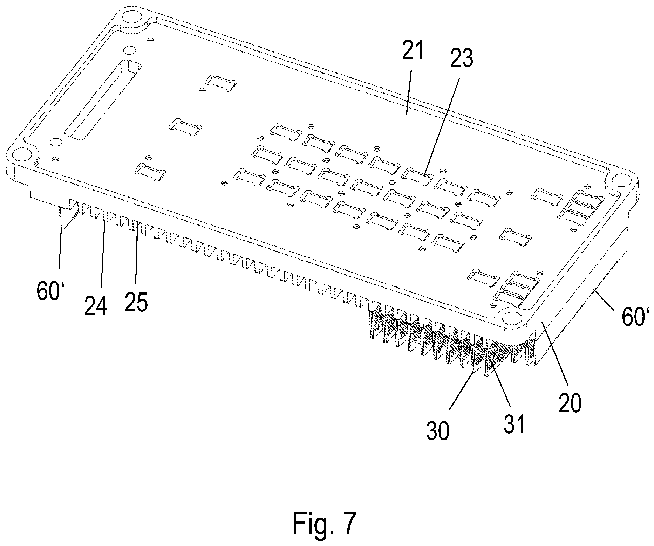

Figur 7 zeigt den Boden 21 der Basisplatte 20, der an dem zumindest einen elektronischen Bauteil 11 angeordnet ist, indem er mit reliefartigen Vertiefungen 23 versehen ist, deren Gestalt und Dimension im Wesentlichen der Kontur des elektronischen Bauteils 11 bzw. der Kontur der bestückten Leiterplatte bzw. der elektronischen Baugruppe entspricht. Das elektronische Bauteil 11 ist hierbei an einer Leiterplatte 10 angeordnet. Die Basisplatte 20 kontaktiert das elektronische Bauteil 11 so, dass zwischen der Oberfläche des elektronischen Bauteils 11 und den reliefartigen Vertiefungen 23 des Bodens 21 der Basisplatte 20 im Wesentlichen nur ein dünner Spalt gebildet wird. Dieser dünne Spalt ist mit einem gut wärmeleitfähigem Material wie Wärmeleit-Paste, -Gel, -Phase-change Material, -Schaumstoff oder -Vergussmasse luftfrei ausgefüllt. Die reliefartigen Vertiefungen 23 ermöglichen ferner die im Wesentlichen luftspaltfreie Kontaktierung, wie oben beschrieben, der Leiterplatte 10 durch den Boden 21 der Basisplatte 20. Die Vertiefungen sind durch den Stand der Technik bekannte Methoden wie beispielsweise durch Fräsen oder Prägen herstellbar.

Im Weiteren wird nochmals auf Figur 1 und 2 Bezug genommen. Wie in Figur 1 ersichtlich weist die Wärmeableitungsvorrichtung 100 zumindest einen über den Wärmeableitungslamellen 30 angeordneten elektrischen Lüfter 40 auf. Dieser Lüfter 40 bläst im Betrieb einen Luftstrom, ersichtlich in Figur 2, in die offenen zweiten 32 Luftströmungskanäle. Die Luftzuströmung 71 und die Luftabströmung 71' erfolgen vorzugsweise über unterschiedliche Achsen. Beispielsweise kann die Luftzuströmung 71 über eine vertikale Achse erfolgen und die Luftabströmung 71' über eine quer zur vertikalen Achse verlaufende horizontale Achse oder umgekehrt, wenn der Lüfter 40 statt im Blasbetrieb im Saugbetrieb betrieben wird. Die größte Wärmeübertragung erfolgt dabei vorwiegend innerhalb der Vielzahl von Belüftungslöchern 31 und/oder Belüftungsschlitzen 31' der Wärmeableitungslamellen 30, wobei der Luftstrom 70 die Belüftungslöcher 31 und/oder Belüftungsschlitze 31' vorzugsweise nur einmal passiert.

Der zumindest eine Lüfter 40 ist an den Stirnseiten der Basisplatte 20 oder an sich an den oder nahe der Stirnseiten der Basisplatte 20 erhebenden Seitenwänden 60` montiert. Alternativ ist der zumindest eine Lüfter mittels eines mit allen Wärmeableitungslamellen 30 an den distalen Enden 34` der zweiten Luftströmungskanäle 34 verbundenen Montageelements 60 an den Stirnseiten der Basisplatte oder an sich an den oder nahe der Stirnseiten der Basisplatte erhebenden Seitenwänden 60` montiert. Das Material des Montageelements 60 ist vorzugsweise Kunststoff, wobei das Montageelement 60 auch aus jedem anderen Material wie z. B. Metall sein kann. Der zumindest eine Lüfter 40 ist mit dem Montageelement 60 mittels Befestigungsmittel wie z. B. Schrauben 80 verbunden, wobei der Lüfter 40 mit dem Montageelement 60 auch verklebt sein kann.

Bei elektronischen Bauteilen mit besonders starker Wärmeabgabe und/oder bei der Kühlung von einer Vielzahl von elektronischen Bauteilen ist es vorgesehen einen zweiten 40` elektrischen Lüfter über den Wärmeableitungslamellen 30, parallel zu dem ersten 40 Lüfter anzuordnen. Dieser zweite Lüfter weist im Wesentlichen die gleichen technischen Eigenschaften auf, als der zuvor beschriebene erste 40 elektrische Lüfter. In einer alternativen Ausführung ist es vorgesehen, dass der zur Kühlung der elektronischen Bauteile 11 notwendige Luftstrom 70 ohne den Gebrauch eines Lüfters 40,41 erzeugt werden kann. So kann beispielsweise der durch ein bewegtes Fahrzeug, z. B. ein Motorrad, erzeugte Fahrtwind als Luftstrom 70 zur Kühlung der oben genannten elektronischen Bauteile 11 verwendet werden.

## Patentansprüche

1. Wärmeableitungsvorrichtung (100) zur Anordnung an zumindest einem elektronischen Bauteil (11), umfassend eine wärmeleitende Basisplatte (20) mit einem Boden (21) und einer vom Boden (21) abgewandten Oberseite (22), wobei sich zwischen zwei einander gegenüberliegenden Stirnseiten der Basisplatte (20) Wärmeableitungslamellen (30) von der Oberseite (22) der Basisplatte (20) quer über die Basisplatte und in Bezug auf die Oberseite (22) der Basisplatte (20) geneigt erstrecken, wobei die Neigungen der Wärmeableitungslamellen (30) in Bezug auf die Oberseite (22) der Basisplatte (20) so ausgebildet sind, dass benachbarte Wärmeableitungslamellen (30) abwechselnd aufeinander zulaufen und voneinander weglaufen, wobei die benachbarten, aufeinander zulaufenden Wärmeableitungslamellen (30) an ihren von der Oberseite (22) der Basisplatte (20) abgewandten Endbereichen direkt oder mittels einer Deckwand (32) miteinander verbunden sind und einen ersten Luftströmungskanal (33) begrenzen, und wobei die benachbarten, voneinander weglaufenden Wärmeableitungslamellen (30) einen zweiten Luftströmungskanal (34) begrenzen, der an seiner von der Oberseite (22) der Basisplatte (20) abgewandten Seite offen ist, wobei die Wärmeableitungslamellen (30) eine Vielzahl von Belüftungslöchern (31) und/oder Belüftungsschlitzen (31') aufweisen, **dadurch gekennzeichnet, dass** die ersten Luftströmungskanäle (33) an ihren einander gegenüberliegenden distalen Enden (33') offen und die zweiten Luftströmungskanäle (34) an ihren einander gegenüberliegenden distalen Enden (34') geschlossen ausgebildet sind.

2. Wärmeableitungsvorrichtung (100) nach Anspruch 1, **dadurch gekennzeichnet, dass** die ersten Luftströmungskanäle (33) eine im Wesentlichen trapezförmige Querschnittsform aufweisen.

3. Wärmeableitungsvorrichtung (100) nach Anspruch 1 oder 2, **dadurch gekennzeichnet, dass** die distalen Enden (34') der zweiten Luftströmungskanäle (34) durch Quetschung der Enden geschlossen ausgebildet sind.

4. Wärmeableitungsvorrichtung (100) nach einem der vorhergehenden Ansprüche, **dadurch gekennzeichnet, dass** die Summe der Querschnittsflächen aller ersten Luftströmungskanäle (33) kleiner ist als die Summe der Flächen der Belüftungslöcher (31) bzw. Belüftungsschlitze (31') in den die ersten Luftströmungskanäle (33) begrenzenden Wärmeableitungslamellen (30).

5. Wärmeableitungsvorrichtung (100) nach einem der vorhergehenden Ansprüche, **dadurch gekennzeichnet, dass** die Oberseite (22) der Basisplatte (20) Rippen (24) aufweist, auf denen die Wärmeableitungslamellen (30) angeordnet sind.

6. Wärmeableitungsvorrichtung (100) nach einem der vorhergehenden Ansprüche, **dadurch gekennzeichnet, dass** die Oberseite (22) der Basisplatte (20) Schlitze (25) aufweist, in die die Wärmeableitungslamellen (30) eingesetzt sind.

7. Wärmeableitungsvorrichtung (100) nach Anspruch 5 oder 6, **dadurch gekennzeichnet, dass** Wärmeableitungslamellen mit den Rippen (24) oder Schlitzen (25) mittels einer stoffschlüssigen Verbindung, insbesondere einer wärmeleitfähigen Klebeverbindung, verbunden sind.

8. Wärmeableitungsvorrichtung (100) nach einem der vorangehenden Ansprüche, **dadurch gekennzeichnet, dass** die Wärmeableitungslamellen (30) aus Kupfer oder Aluminium bestehen.

9. Wärmeableitungsvorrichtung (100) nach einem der vorangehenden Ansprüche, **dadurch gekennzeichnet, dass** die Basisplatte aus einem Metall, insbesondere Aluminium, Kupfer, einem Kupfer-Aluminium Verbund oder einer Legierung besteht.

10. Wärmeableitungsvorrichtung (100) nach Anspruch 9, **dadurch gekennzeichnet, dass** die Oberflächen der Basisplatte (20) zumindest in jenen Abschnitten, die zum Anliegen an dem zumindest einen elektronischen Bauteil (11) vorgesehen sind, eine elektrisch isolierende Schicht, insbesondere eine Eloxalschicht, aufweisen.

11. Wärmeableitungsvorrichtung (100) nach einem der vorangehenden Ansprüche, **dadurch gekennzeichnet, dass** der Boden (21) der Basisplatte (20) dazu ausgebildet ist, an dem zumindest einen elektronischen Bauteil (11) angeordnet zu werden, indem er mit reliefartigen Vertiefungen (23) versehen ist, deren Gestalt und Dimension im Wesentlichen der Kontur des elektronischen Bauteils (11) entspricht.

12. Wärmeableitungsvorrichtung (100) nach einem der vorangehenden Ansprüche, **dadurch gekennzeichnet, dass** die Belüftungslöcher (31) der Wärmeableitungslamellen (30) als Rundlöcher und/oder Langlöcher ausgebildet sind.

13. Wärmeableitungsvorrichtung (100) nach einem der vorangehenden Ansprüche, **dadurch gekennzeichnet, dass** die Belüftungsschlitze (31`) der Wärmeableitungslamellen (30) parallel zueinander und senkrecht auf die Oberseite (22) der Basisplatte (20) stehend in den Wärmeableitungslamellen (30) ausgebildet sind.

14. Wärmeableitungsvorrichtung (100) nach einem der vorhergehenden Ansprüche, **dadurch gekennzeichnet, dass** die Wärmeableitungslamellen (30) als Strangpressprofile ausgebildet sind.

15. Wärmeableitungsvorrichtung (100) nach einem der vorhergehenden Ansprüche, **dadurch gekennzeichnet, dass** sie zumindest einen über den Wärmeableitungslamellen (30) angeordneten elektrischen Lüfter (40) aufweist.

16. Wärmeableitungsvorrichtung (100) nach Anspruch 15, **dadurch gekennzeichnet, dass** der Lüfter (40) im Betrieb einen Luftstrom (70) in die offenen zweiten Luftströmungskanäle (34) bläst.

17. Wärmeableitungsvorrichtung (100) nach Anspruch 15 oder 16, **dadurch gekennzeichnet, dass** der zumindest eine Lüfter (40) an den Stirnseiten der Basisplatte (20) oder an sich an den oder nahe der Stirnseiten der Basisplatte (20) erhebenden Seitenwänden (60') montiert ist.

18. Wärmeableitungsvorrichtung (100) nach Anspruch 17, **dadurch gekennzeichnet, dass** der zumindest eine Lüfter (40) mittels eines mit allen Wärmeableitungslamellen (30) an den distalen Enden (34') der zweiten Luftströmungskanäle (34) verbundenen Montageelements (60) an den an den Stirnseiten der Basisplatte oder an sich an den oder nahe der Stirnseiten der Basisplatte (20) erhebenden Seitenwänden (60') montiert ist.

19. Wärmeableitungsvorrichtung (100) nach einem der vorhergehenden Ansprüche, **dadurch gekennzeichnet, dass** die Wärmeableitungslamellen (30) als trapezförmige Spiralfedern ausgebildet sind.

## Claims

1. A heat discharge device (100) for arrangement on at least one electronic component (11), comprising a heat conductive bottom plate (20) having a bottom (21) and an upper surface (22) facing away from the bottom (21), wherein heat discharge blades (30) extend between two opposite front faces of the bottom plate (20) from the upper surface (22) of the bottom plate (20) transversely across the bottom plate and inclined in respect to the upper surface (22) of the bottom plate (20), wherein the inclinations of the heat discharge blades (30) in respect to the upper surface (22) of the bottom plate (20) are configured in a way such that neighbouring heat discharge blades (30) alternatingly approach one another and move away from each other, wherein the neighbouring heat discharge blades (30) approaching one another are connected to one another at the end regions thereof facing away from the upper surface (22) of the bottom plate (20) directly or by means of a cover wall (32) and delimit a first air flow channel (33), and wherein the neighbouring heat discharge blades (30) moving away from one another delimit a second air flow channel (34), which is open at the side thereof facing away from the upper surface (22) of the bottom plate (20), wherein the heat discharge blades (30) have a plurality of air holes (31) and/or air vents (31'), **characterized in that** the first air flow channels (33) are configured to be open at the opposite distal ends (33') thereof and the second air flow channels (34) are configured to be closed at the opposite distal ends (34') thereof.

2. A heat discharge device (100) according to claim 1, **characterized in that** the first air flow channels (33) have an essentially trapezoid cross-sectional shape.

3. A heat discharge device (100) according to claim 1 or 2, **characterized in that** the distal ends (34`) of the second air flow channels (34) are configured to be closed by crimping the ends.

4. A heat discharge device (100) according to any of the preceding claims, **characterized in that** the sum of the cross-section areas of all first air flow channels (33) is smaller than the sum of the areas of the air holes (31) or air vents (31'), respectively, in the heat discharge blades (30) delimiting the first air flow channels (33).

5. A heat discharge device (100) according to any of the preceding claims, **characterized in that** the upper surface (22) of the bottom plate (20) has ribs (24), on which there are arranged the discharge blades (30).

6. A heat discharge device (100) according to any of the preceding claims, **characterized in that** the upper surface (22) of the bottom plate (20) has slits (25), into which the heat discharge blades (30) are inserted.

7. A heat discharge device (100) according to claim 5 or 6, **characterized in that** heat discharge blades are connected to the ribs (24) or slits (25) by means of a material bond, in particular a heat conductive adhesive bond.

8. A heat discharge device (100) according to any of the preceding claims, **characterized in that** the heat discharge blades (30) are composed of copper or aluminium.

9. A heat discharge device (100) according to any of the preceding claims, **characterized in that** the bottom plate is composed of a metal, in particular aluminium, copper, a copper-aluminium-composite or an alloy.

10. A heat discharge device (100) according to claim 9, **characterized in that** surfaces of the bottom plate (20) have at last in those portions, which are provided for abutment to an electronic component (11), an electrically insulating layer, in particular an anodized layer.

11. A heat discharge device (100) according to any of the preceding claims, **characterized in that** the bottom (21) of the bottom plate (20) is configured to be arranged at the at least one electronic component (11) by being provided with relief-like recesses (23), the shape and dimension of which essentially corresponding to the contour of the electronic component (11).

12. A heat discharge device (100) according to any of the preceding claims, **characterized in that** the air holes (31) of the heat discharge blades (30) are configured as round holes and/or elongate holes.

13. A heat discharge device (100) according to any of the preceding claims, **characterized in that** the air vents (31') of the heat discharge blades (30) are configured in parallel to one another and orthogonal to the upper surface (22) of the bottom plate (20) upright within the heat discharge blades (30).

14. A heat discharge device (100) according to any of the preceding claims, **characterized in that** the heat discharge blades (30) are configured as extruded sections.

15. A heat discharge device (100) according to any of the preceding claims, **characterized in that** it has at least one electric ventilator (40) arranged above the heat discharge blades (30).

16. A heat discharge device (100) according to claim 15, **characterized in that** the ventilator (40) in operation blows an air flow (70) into the open second air flow channels (34).

17. A heat discharge device (100) according to claim 15 or 16, **characterized in that** the at least one ventilator (40) is mounted at the front faces of the bottom plate (20) or at side walls (60') extending upwards at or near the front faces of the bottom plate (20).

18. A heat discharge device (100) according to claim 17, **characterized in that** the at least one ventilator (40) is mounted at the front faces of the bottom plate or at side walls (60') extending upwards at or near the front faces of the bottom plate (20) by means of a mounting element (60) connected to all heat discharge blades (30) at the distal ends (34') of the second air flow channels (34).

19. A heat discharge device (100) according to any of the preceding claims, **characterized in that** the heat discharge blades (30) are configured as trapezoid coil springs.

## Revendications

1. Dispositif de dissipation de chaleur (100) destiné à être agencé sur au moins un composant électronique (11), comprenant une plaque de base conductrice de chaleur (20) qui présente une base (21) et un côté supérieur (22) opposé à la base (21), dans lequel des lamelles de dissipation de chaleur (30) s'étendent entre deux côtés d'extrémité opposés de la plaque de base (20) à partir du côté supérieur (22) de la plaque de base (20), transversalement à la plaque de base et de façon inclinée par rapport au côté supérieur (22) de la plaque de base (20), dans lequel les inclinaisons des lamelles de dissipation de chaleur (30) par rapport au côté supérieur (22) de la plaque de base (20) sont formées de telle sorte que des lamelles de dissipation de chaleur voisines (30) s'étendent alternativement l'une vers l'autre et s'éloignent l'une de l'autre, dans lequel les lamelles de dissipation de chaleur voisines (30) qui s'étendent l'une vers l'autre sont reliées l'une à l'autre directement ou au moyen d'une paroi de recouvrement (32) au niveau de leurs zones d'extrémité tournées à l'opposé du côté supérieur (22) de la plaque de base (20) et délimitent un premier canal d'écoulement d'air (33), dans lequel les lamelles de dissipation de chaleur voisines (30) qui s'étendent à l'opposé l'une de l'autre délimitent un second canal d'écoulement d'air (34) qui est ouvert sur le côté opposé au côté supérieur (22) de la plaque de base (20), et dans lequel les lamelles de dissipation de chaleur (30) comportent une pluralité de trous de ventilation (31) et/ou de fentes de ventilation (31'), **caractérisé en ce que** les premiers canaux d'écoulement d'air (33) sont ouverts au niveau de leurs extrémités distales opposées (33') et les seconds canaux d'écoulement d'air (34) sont conçus de manière à être fermés au niveau de leurs extrémités distales opposées (34').

2. Dispositif de dissipation de chaleur (100) selon la revendication 1, **caractérisé en ce que** les premiers canaux d'écoulement d'air (33) présentent une forme de section transversale sensiblement trapézoïdale.

3. Dispositif de dissipation de chaleur (100) selon la revendication 1 ou 2, **caractérisé en ce que** les extrémités distales (34') des seconds canaux d'écoulement d'air (34) sont conçues de manière à être fermées par un pincement desdites extrémités.

4. Dispositif de dissipation de chaleur (100) selon l'une quelconque des revendications précédentes, **caractérisé en ce que** la somme des surfaces de section transversale de la totalité des premiers canaux d'écoulement d'air (33) est inférieure à la somme des surfaces des trous de ventilation (31) ou des fentes de ventilation (3 1') dans les lamelles de dissipation de chaleur (30) qui délimitent les premiers canaux d'écoulement d'air (33).

5. Dispositif de dissipation de chaleur (100) selon l'une quelconque des revendications précédentes, **caractérisé en ce que** le côté supérieur (22) de la plaque de base (20) comporte des ailettes (24) sur lesquelles les lamelles de dissipation de chaleur (30) sont agencées.

6. Dispositif de dissipation de chaleur (100) selon l'une quelconque des revendications précédentes, **caractérisé en ce que** le côté supérieur (22) de la plaque de base (20) comporte des fentes (25) à l'intérieur desquelles les lamelles de dissipation de chaleur (30) sont insérées.

7. Dispositif de dissipation de chaleur (100) selon la revendication 5 ou 6, **caractérisé en ce que** des lamelles de dissipation de chaleur sont reliées aux ailettes (24) ou aux fentes (25) par l'intermédiaire d'une liaison matérielle, en particulier une liaison adhésive thermo-conductrice.

8. Dispositif de dissipation de chaleur (100) selon l'une quelconque des revendications précédentes, **caractérisé en ce que** les lamelles de dissipation de chaleur (30) sont constituées de cuivre ou d'aluminium.

9. Dispositif de dissipation de chaleur (100) selon l'une quelconque des revendications précédentes, **caractérisé en ce que** la plaque de base est constituée d'un métal, en particulier l'aluminium, le cuivre, un composite de cuivre - aluminium ou un alliage.

10. Dispositif de dissipation de chaleur (100) selon la revendication 9, **caractérisé en ce que** les surfaces de la plaque de base (20) sont revêtues d'une couche électriquement isolante, en particulier une couche d'anodisation, au moins dans les parties qui sont destinées à entrer en contact avec ledit au moins un composant électronique (11).

11. Dispositif de dissipation de chaleur (100) selon l'une quelconque des revendications précédentes, **caractérisé en ce que** la base (21) de la plaque de base (20) est apte à être agencée sur ledit au moins un composant électronique (11) en comportant des évidements en relief (23) dont la forme et les dimensions correspondent sensiblement au contour dudit composant électronique (11).

12. Dispositif de dissipation de chaleur (100) selon l'une quelconque des revendications précédentes, **caractérisé en ce que** les trous de ventilation (31) des lamelles de dissipation de chaleur (30) sont des trous ronds et/ou des trous oblongs.

13. Dispositif de dissipation de chaleur (100) selon l'une quelconque des revendications précédentes, **caractérisé en ce que** les fentes de ventilation (31') des lamelles de dissipation de chaleur (30) sont agencées parallèlement les unes aux autres et perpendiculairement au côté supérieur (22) de la plaque de base (20) dans les lamelles de dissipation de chaleur (30).

14. Dispositif de dissipation de chaleur (100) selon l'une quelconque des revendications précédentes, **caractérisé en ce que** les lamelles de dissipation de chaleur (30) sont réalisées sous la forme de profilés extrudés.

15. Dispositif de dissipation de chaleur (100) selon l'une quelconque des revendications précédentes, **caractérisé en ce qu'**il comprend au moins un ventilateur électrique (40) qui est agencé au-dessus des ailettes de dissipation de chaleur (30).

16. Dispositif de dissipation de chaleur (100) selon la revendication 15, **caractérisé en ce que** le ventilateur (40), en fonctionnement, insuffle un flux d'air (70) à l'intérieur des seconds canaux d'écoulement d'air ouverts (34).

17. Dispositif de dissipation de chaleur (100) selon la revendication 15 ou 16, **caractérisé en ce que** ledit au moins un ventilateur (40) est monté sur les côtés d'extrémité de la plaque de base (20) ou sur des parois latérales (60') qui s'élèvent au niveau ou à proximité des côtés d'extrémité de la plaque de base (20).

18. Dispositif de dissipation de chaleur (100) selon la revendication 17, **caractérisé en ce que** ledit au moins un ventilateur (40) est monté sur les parois latérales (60') qui s'élèvent sur les côtés d'extrémité de la plaque de base ou sur les parois latérales (60') qui s'élèvent sur les côtés d'extrémité ou à proximité des côtés d'extrémité de la plaque de base (20) par l'intermédiaire d'un élément de montage (60) qui est relié à la totalité des ailettes de dissipation de chaleur (30) au niveau des extrémités distales (34') des seconds canaux de circulation d'air (34).

19. Dispositif de dissipation de chaleur (100) selon l'une quelconque des revendications précédentes, **caractérisé en ce que** les lamelles de dissipation de chaleur (30) sont des ressorts hélicoïdaux de forme trapézoïdale.
